# DEMANDE DE BREVET EUROPEEN

(11) **EP 3 547 028 A1**
(43) Date de publication de la demande: **02.10.2019**
(21) Numéro de dépôt: 18164603.5
(22) Date de dépôt: 28.03.2018
(51) Int. Cl.: G03F 7/038, G03F 7/16

(54) **METHODE DE PREPARATION DE RESINE PHOTOSENSIBLE SECHE ET RESINE PHOTOSENSIBLE OBTENUE PAR LA METHODE**

(71) Demandeur: Mimotec S.A., 1950 Sion (CH)
(72) Inventeur: BAGNOUD, Thomas, 1950 Sion (CH); GENOLET, Grégoire, 1926 Fully (CH)
(74) Mandataire: Wenger, Joel-Théophile

(57) **Abrégé**

Méthode de préparation de résine photosensible sèche destinée à être utilisée dans la fabrication de micromoules pour électroformage de composants micromécaniques, la résine photosensible comprenant un polymère d'époxyde (EPO), un photo-initiateur et des additifs (PHI & ADD). La méthode comprend des étapes de dissolution et mélange du polymère d'époxyde (EPO), du photo-initiateur et additifs (PHI & ADD) dans un solvant (SOL B) et de filtrage facultatif du mélange initial obtenu en éliminant des impuretés et des résidus de résine solides ayant un diamètre global prédéterminé. La méthode est caractérisée en ce que le mélange initial a une viscosité dynamique inférieure ou égale à 2 Pa*s dépendant de la quantité de solvant (SOL B) dans ledit mélange initial et en ce qu'elle comprend des étapes d'atomisation du mélange après filtrage afin d'éliminer le solvant (SOL B) et d'obtention d'une poudre de résine photosensible (PDR SU8) exempte de solvant (SOL B). La poudre de résine photosensible (PDR SU8) obtenue a une granulométrie contrôlée notamment par la quantité de polymère d'époxyde (EPO) et par l'ajout d'un solvant supplémentaire (SOL A) dans le mélange initial.

## Description

La présente demande concerne le domaine de la préparation de résine photosensible sèche destinée à être utilisée dans la fabrication de micromoules pour électroformage de composants micromécaniques de haute précision.

### Arrière-plan technique

Les résines photosensibles sont couramment utilisées dans de nombreuses applications notamment dans les domaines des semi-conducteurs et de la fabrication de composants micromécaniques.

Un procédé connu décrit dans le brevet européen No : EP0851295B1 est dérivé de la technique LIGA (Lithographie Galvanoformung Abformung) consiste à :
- déposer sur un substrat une couche de 1 à 1000 µm d'une résine photosensible,
- effectuer à travers un masque une irradiation au moyen d'un synchrotron ou par une exposition de rayons ultraviolets UV,
- développer, c'est-à-dire éliminer par des moyens chimiques les portions de photorésist non polymérisées et créer de ce fait une cavité en photorésist.
- électroformer un métal dans cette cavité afin d'obtenir le composant micromécanique.

La couche de résine photosensible aussi appelée photorésist peut être du type négatif ou positif où l'exposition au rayonnement UV respectivement diminue ou augmente la solubilité de la résine dans un solvant de développement.

Les couches de photorésist utilisées dans le procédé LIGA sont soit formées à partir de photorésist liquide puis séchées ou recuites afin d'en éliminer le solvant, soit formées à partir de photorésist sec appliqué et mis en forme à chaud sur le substrat.

L'utilisation d'un photorésist sec est avantageuse car le temps de séchage avant irradiation est fortement réduit voire éliminé grâce à sa faible teneur en solvant et il permet en outre de réaliser des couches épaisses de plusieurs millimètres.

Le document WO2006/124552A2 (MicroChem Corp.) décrit une méthode de préparation d'une feuille de photorésist comprenant des étapes suivantes : préparer une composition de photorésist thermoplastique, appliquer le photorésist thermoplastique sur un substrat à l'aide d'une matrice d'extrusion à fente (slot-die coating), refroidir suffisamment le photorésist thermoplastique afin d'empêcher son écoulement, appliquer une feuille de protection sur la surface opposée à celle partiellement refroidie, et obtenir une feuille de photorésist. Cette feuille de photorésist est ensuite pressée à chaud de manière à obtenir une épaisseur prédéterminée.

La composition du photorésist thermoplastique comprend au moins une résine polyfonctionnelle qui peut réagir avec elle-même ou avec un additif en présence d'un catalyseur photo-généré ou de réactifs particuliers et un matériau photosensible thermiquement stable. Ce matériau photosensible engendre une polymérisation ou une modification structurelle de la résine lorsqu'elle est exposée à un rayonnement ultraviolet par exemple. Cette composition de photorésist contient un faible taux de solvant situé entre 0% et 5%.

### Description sommaire de l'invention

La méthode de préparation décrite par le document WO2006/124552A2 permet de préparer des feuilles de photorésist plus ou moins solides destinées à être appliquées à chaud sur des substrats. Le but de la présente invention est d'obtenir une poudre sèche de photorésist exempte de solvant ou, selon une variante, avec une quantité de solvant prédéterminée prête à être mise en oeuvre pour des applications de haute précision.

L'utilisation du photorésist sec s'est montrée d'une grande efficacité et permet de simplifier le procédé avec des étapes ne nécessitant qu'un minimum de temps et d'énergie.

Ce but est atteint par une méthode de fabrication de résine photosensible sèche destinée à être utilisée dans la fabrication de micromoules pour électroformage de composants micromécaniques selon la revendication 1.

La méthode de la présente invention permet de fabriquer une résine photosensible sèche sous forme de poudre selon la revendication 9.

### Description sommaire des figures

L'invention sera mieux comprise grâce à la description qui va suivre et qui se réfère aux dessins annexés donnés à titre d'exemple nullement limitatif, à savoir :
La figure 1 montre un organigramme des étapes de préparation de photorésist sec selon l'art antérieur.
La figure 2 montre un organigramme des étapes de préparation de photorésist sec selon la présente invention

### Description détaillée de l'invention

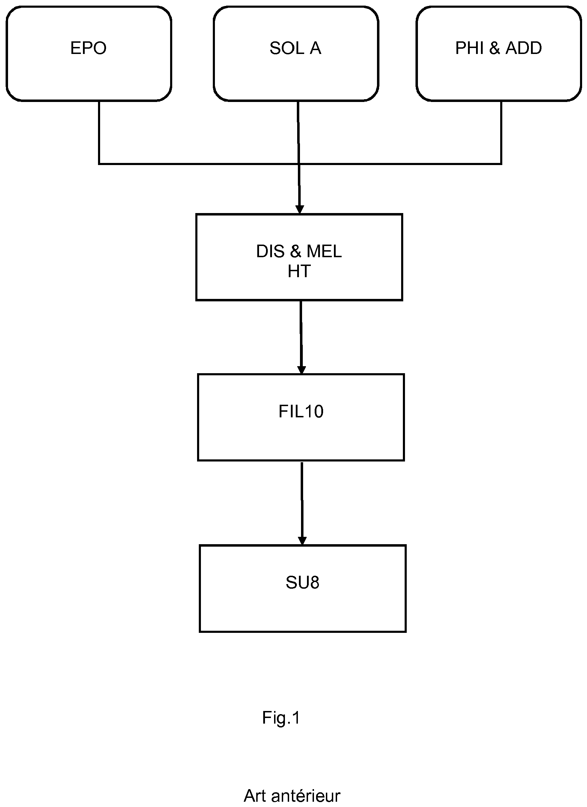

L'organigramme de la figure 1 illustre les principales étapes de fabrication d'une feuille de photorésist selon l'état de la technique le plus proche représenté par la publication WO2006/124552A2.

Les composants de base utilisés pour la fabrication de la résine finale ou feuille de photorésist du type SU8 comprennent un polymère d'époxyde EPO, un photo-initiateur avec des additifs PHI & ADD et un solvant SOL A.

Le polymère d'époxyde EPO comprend une large gamme de matériaux réactifs tels que des éthers de vinyle, silicones, polyuréthanes, formais, t-butyl esters, t-butoxycarbonylesters. Selon une variante préférée, le polymère d'époxyde est une résine novolac ou une résine cycloaliphatique ou un mélange de celles-ci entièrement ou partiellement époxydée.

Le photo-initiateur PHI comprend des générateurs de photo-acides consistant en des sels de triaryl sulfonium ou de diaryl iodonium. Des sels de hexafluorophosphate ou hexafluoroantimonate et des acides forts tels que l'acide tetra(perfluorophenyl)borique ou tris(trifluoromethylsulfonium)methide peuvent également être utilisés. Le photo-initiateur PHI est en général dilué dans un solvant comme du carbonate de propylène.

Les additifs ADD comprennent un ou plusieurs matériaux parmi lesquels : des résines non réactives, des monomères réactifs, des photosensibilisateurs, promoteurs d'adhérence, des composés absorbant la lumière comprenant des colorants, des pigments et les phosphores, des agents de nivellement de surface. Des matériaux supplémentaires comme des agents de régulation de débit, des polymères et résines organiques thermodurcissables, ainsi que des charges organiques et inorganiques peuvent également être présents.

Le solvant SOL A comprend par exemple de l'acétone, du methyl éthyle ketone, du pentanone, du cyclopentanone, du gamma-butyrolactone, de l'éthyle acétate ou dioxolane. La quantité de solvant SOL A utilisé se situe entre 0% et 5% du volume des autres composants de base.

Les composants de base et le solvant SOL A sont dissous et mélangés DIS & MEL dans un réacteur chimique à haute température HT entre 90°C et 150°C. Le mélange obtenu a une viscosité dynamique élevée plus grande ou égale à 10.7 Pa*s. Cette viscosité environ 10000 fois plus élevée que celle de l'eau froide à 20°C qui vaut 1*10⁻³ Pa*s dépend essentiellement de la température du mélange.

Le solvant SOL A dont le point d'ébullition peut être relativement élevé est entièrement éliminé lors de l'étape de dissolution et mélange DIS & MEL des composants de base à haute température HT.

Le mélange est ensuite filtré FIL10 afin d'éliminer des impuretés et des résidus de résine solides issus des composants de base. Le filtre utilisé retient typiquement des résidus de résine ayant un diamètre global plus grand ou égal à 10 microns. La feuille de photorésist finale de type SU8 obtenu est solide et exempte de solvant.

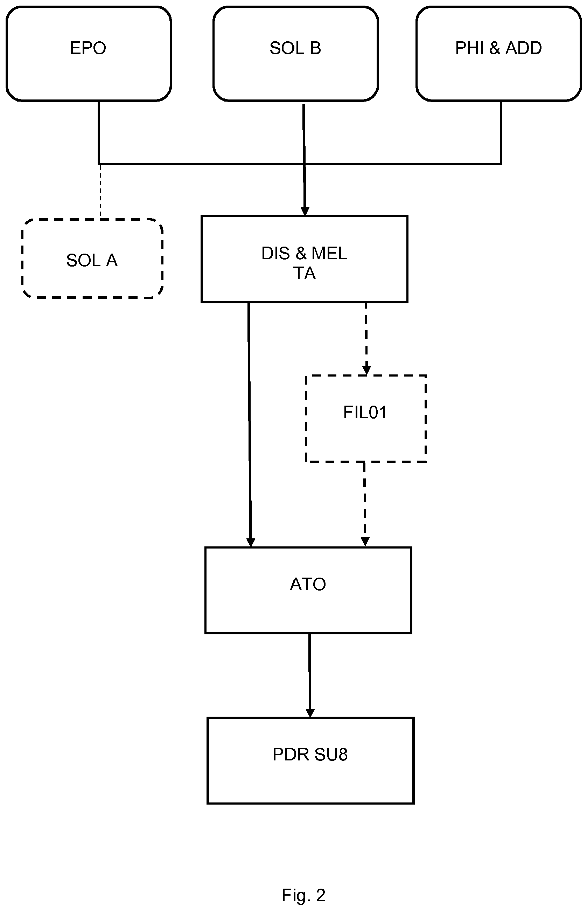

La méthode de la présente invention illustrée par l'organigramme de la figure 2 diffère de celle de l'art antérieur par des étapes moins gourmandes en énergie effectuées en un temps réduit avec une filtration plus poussée. De plus, le produit final se présente sous forme de poudre de photorésist homogène au lieu d'une feuille de photorésist solide. La mise en forme de la poudre par pressage, par exemple, a également l'avantage de permettre d'obtenir des épaisseurs de résine photosensible très variées, indépendamment du matériau de base, au contraire d'une feuille qui a une épaisseur déterminée.

Les composants de base comprenant le polymère d'époxyde EPO et le photo-initiateur avec additifs PHI & ADD sont analogues à ceux utilisé dans la méthode de l'art antérieur. Seul le solvant SOL B et la quantité utilisée diffèrent notamment à cause des étapes ultérieures effectuées à des températures proches de la température ambiante TA définie à 20°C.

En effet, le polymère d'époxyde EPO et le photo-initiateur avec les additifs PHI & ADD sont dissous et mélangés dans une grande quantité de solvant SOL B entre 30% et 90% du volume des composants de base. Cette opération de dissolution et mélange DIS & MEL est de préférence effectuée à température ambiante TA.

Le mélange initial ainsi obtenu a une viscosité dynamique inférieure ou égale à 2 Pa*s à température ambiante qui est déjà 5 fois plus faible ou plus que celle du mélange initial à haute température HT de l'art antérieur. La viscosité dynamique du mélange initial dépend essentiellement de la quantité de solvant SOL B du mélange initial à une température donnée, ici une température proche de la température ambiante TA.

Le mélange initial est ensuite atomisé ATO. Il est introduit dans une enceinte d'atomisation qui pulvérise le mélange initial en fines gouttelettes au contact d'un flux d'air chaud afin d'évaporer et éliminer le solvant SOL B dudit mélange initial. L'atomisation ATO est rendue possible grâce à la faible viscosité due à une quantité relativement grande de solvant SOL B contenue dans le mélange initial.

Etant donné, que le solvant SOL B est de préférence sélectionné parmi les solvants à bas point d'ébullition, la température du flux d'air peut être relativement basse c'est-à-dire inférieure ou égale à 32°C ou proche de la température ambiante TA.

Selon une option, le mélange initial peut être filtré de manière à éliminer des impuretés et autres résidus de résine solides ayant un diamètre global prédéterminé. Cette étape FIL01, indiquée en pointillés sur la figure 2, est effectuée avant l'étape d'atomisation ATO du mélange ainsi filtré. Le filtre est de préférence configuré de manière à éliminer les impuretés et résidus d'un diamètre global supérieur ou égal à 0,1 microns. La faible viscosité du mélange permet ainsi un filtrage 100 fois plus fin que celui de la méthode décrite par le document WO2006/124552A2.

L'exécution ou non de l'étape de filtrage FIL01 dépend de la qualité et de la propreté des composants de base, respectivement du mélange initial.

Le solvant SOL B peut être constitué d'acétone par exemple qui a l'avantage d'être peu onéreux et d'avoir un point d'ébullition peu élevé à 56°C. D'autres solvants ayant un point d'ébullition inférieur à celui de l'eau (100°C) peuvent également être utilisés comme par exemple le cyclopentane, le méthylène chloride ou le méthyl éthyle cétone.

Le produit final obtenu à la sortie de l'enceinte d'atomisation se présente sous forme de poudre PDR SU8 de résine photosensible sèche ou photorésist sec de type SU8 exempte de solvant.

Selon une option de la méthode de l'invention, un solvant supplémentaire SOL A est ajouté aux composants de base EPO, PHI & ADD et SOL B comme indiqué en pointillé sur la figure 2. Ce solvant supplémentaire SOL A a un point d'ébullition plus élevé que celui du solvant SOL B du mélange initial.

En fonction des domaines d'application de la poudre de photorésist, il devient nécessaire d'ajouter ce solvant supplémentaire SOL A dans le mélange initial afin d'obtenir une poudre avec un taux de solvant prédéfini.

Le taux de ce solvant supplémentaire SOL A dans le mélange initial dépend du taux de solvant SOL A désiré dans la poudre de photorésist PDR SU8 finale. Grâce au point d'ébullition plus élevé, ce solvant supplémentaire SOL A n'est évaporé que partiellement dans le flux d'air chaud de l'étape d'atomisation tandis que le solvant SOL B du mélange initial avec un point d'ébullition plus bas peut être éliminé complètement. De ce fait, le taux de solvant supplémentaire SOL A de la poudre finale PDR SU8 peut être contrôlé de manière précise par la quantité de solvant SOL A supplémentaire ajoutée dans le mélange initial.

La poudre de résine photosensible PDR SU8 obtenue selon la méthode de la présente invention composée de polymère d'époxyde EPO, de photo-initiateur et d'additifs PHI & ADD a une granulométrie contrôlée essentiellement par la quantité de polymère d'époxyde EPO dans le mélange initial et/ou par la quantité de solvant supplémentaire SOL A ajouté dans ledit mélange initial. La granulométrie de la poudre se situant entre 1 et 100 microns est proportionnelle à la quantité de polymère d'époxyde EPO et inversément proportionnelle à la quantité de solvant supplémentaire SOL A.

La quantité de solvant supplémentaire SOL A dans la poudre de résine photosensible PDR SU8 se situe en général entre 0 et 5%.

Des paramètres de réglage liés au procédé de fabrication notamment lors de l'étape d'atomisation ATO du mélange initial ou filtré peuvent également influencer la granulométrie de la poudre comme par exemple la taille de l'ouverture de la buse d'atomisation utilisée, la pression d'atomisation, et l'utilisation d'ultrasons ou non lors de l'atomisation.

## Revendications

1. Méthode de préparation de résine photosensible sèche destinée à être utilisée dans la fabrication de micromoules pour électroformage de composants micromécaniques, la résine photosensible comprenant un polymère d'époxyde (EPO), un photo-initiateur et des additifs (PHI & ADD), la méthode comprend les étapes suivantes :
- dissoudre et mélanger le polymère d'époxyde (EPO), le photo-initiateur et les additifs (PHI & ADD) dans un solvant (SOL B), obtention d'un mélange initial, la méthode est **caractérisée en ce que** le mélange initial a une viscosité dynamique inférieure ou égale à 2 Pa*s dépendant de la quantité de solvant (SOL B) dans ledit mélange initial et **en ce qu'**elle comprend les étapes suivantes :
- atomiser le mélange initial par pulvérisation et séchage dans un flux d'air ayant une température prédéterminée, élimination du solvant (SOL B),
- obtention d'une poudre de résine photosensible (PDR SU8) exempte de solvant (SOL B).

2. Méthode selon la revendication 1, **caractérisée en ce qu'**elle comprend une étape de filtrage (FIL01) du mélange initial précédant l'étape d'atomisation (ATO), ladite étape de filtrage (FIL01) éliminant du mélange initial des impuretés et des résidus de résine solides ayant un diamètre global prédéterminé.

3. Méthode selon la revendication 1 ou 2, **caractérisée en ce que** les impuretés et les résidus de résine solides éliminés lors de l'étape de filtrage (FIL01) du mélange initial ont un diamètre global supérieur ou égal à 0.1 microns.

4. Méthode selon l'une quelconque des revendications 1 à 3, **caractérisée en ce que** l'étape de mélange est effectuée à une température proche de la température ambiante (TA) définie à 20°C.

5. Méthode selon l'une quelconque des revendications 1 à 4, **caractérisée en ce que** le solvant (SOL B) utilisé dans l'étape de mélange a un point d'ébullition inférieur à 100°C.

6. Méthode selon l'une quelconque des revendications 1 à 5, **caractérisée en ce que** le mélange filtré est séché dans un flux d'air à une température proche de la température ambiante (TA) inférieure ou égale à 32°C.

7. Méthode selon l'une quelconque des revendications 1 à 6, **caractérisée en ce qu'**elle comprend une étape d'ajout d'un solvant supplémentaire (SOL A) dans le mélange initial, ledit solvant supplémentaire (SOL A) ayant un point d'ébullition plus élevé que celui du solvant (SOL B) du mélange initial.

8. Méthode selon la revendication 7, **caractérisée en ce que** la poudre de résine photosensible (PDR SU8) contient un solvant supplémentaire (SOL A) dont le taux est dépendant de la quantité dudit solvant supplémentaire (SOL A) ajouté dans le mélange initial, le solvant (SOL B) du mélange initial ayant été éliminé lors de l'étape d'atomisation (ATO).

9. Poudre de résine photosensible (PDR SU8) composée de polymère d'époxyde (EPO), de photo-initiateur et d'additifs (PHI & ADD) et **caractérisée en ce qu'**elle a une granulométrie contrôlée par la quantité de polymère d'époxyde (EPO) dans un mélange initial ou filtré et/ou par une quantité de solvant supplémentaire (SOL A) ajouté dans ledit mélange initial ou filtré et/ou par des paramètres de réglages liés au procédé de fabrication.

10. Poudre de résine photosensible (PDR SU8) selon la revendication 9 fabriquée selon la méthode de la revendication 8, **caractérisée en ce que** la granulométrie se situe entre 1 et 100 microns, ladite granulométrie étant dépendante des paramètres de réglages liés à l'étape d'atomisation (ATO), de la quantité de polymère d'époxyde (EPO) dans le mélange initial et de la quantité de solvant supplémentaire (SOL A) ajouté dans ledit mélange initial.

11. Poudre de résine photosensible (PDR SU8) selon la revendication 10, **caractérisée en ce que** la quantité de solvant supplémentaire (SOL A) se situe entre 0 et 5%.
